Europäisches Patentamt

European Patent Office

Office européen des brevets

(11) Publication number: **0 331 289**
**A2**

## EUROPEAN PATENT APPLICATION

(21) Application number: **89300973.8**

(51) Int. Cl.⁴: **H01L 23/56**

(22) Date of filing: **01.02.89**

| | |
|---|---|
| The title of the invention has been amended (Guidelines for Examination in the EPO, A-III, 7.3). | (71) Applicant: **HITACHI, LTD.** **6, Kanda Surugadai 4-chome Chiyoda-ku Tokyo 101(JP)** |
| (30) Priority: **26.02.88 JP 41995/88** **14.03.88 JP 61626/88** | (72) Inventor: **Kamada, Chiyoshi** **205, Hitachi-dai 3 Nakamachiso 489-1,Naka-machi Kodaira-shi Tokyo(JP)** |
| (43) Date of publication of application: **06.09.89 Bulletin 89/36** | |
| (84) Designated Contracting States: **DE FR GB IT** | (74) Representative: **Calderbank, Thomas Roger et al** **MEWBURN ELLIS & CO. 2/3 Cursitor Street London EC4A 1BQ(GB)** |

(54) **Semiconductor device with impedance matching means.**

(57) The operation rate achievable in a high speed LSI is increasing year by year, but has the problem of causing reflection or loss of signal due to mismatching of impedance in the device. It is proposed to achieve impedance matching with the inpackage transmission line in order to prevent mismatching of impendance. In a semiconductor device, a signal wire (5) extends in a direction perpendicular to the main surface of a semiconductor chip (1). A plurality of constant voltage wires (6, 7) are provided around the signal wire to give the effect of a coaxial cable. Hence, by adjusting the relationship between the signal wire (5) and the constant voltage wires (6, 7), the impedance may be adjusted. The central region of a metal cap (8) encapsulating the package is formed thicker than the peripheral part thereof. A low-pass filter may also be connected to the transmission line and a bonding wire is also added to this filter.

FIG. 2

## SEMICONDUCTOR DEVICE

The present invention relates to a semiconductor device particularly, but not exclusively, for transmitting a high frequency signal at a microwave band (several GHz or higher).

A semiconductor chip is located within a cavity of a package and is connected to signal wiring, which is a part of the wiring (transmission line) for high frequency transmission, within a substrate (base) of the package via a bonding wire. This signal wiring extends in a direction parallel to the main surface of the semiconductor chip within the package and is then connected to the outer lead. In known semiconductor devices of this type, the signal line is a microstrip line or a strip line when a semiconductor chip in the package operates in the microwave band. The high speed signal is absorbed by a termination resistor connected to the terminal (i.e. on the opposite side of the signal wire) of the transmission line.

The loading surface of the semiconductor chip is recessed slightly relative to the surface of the signal wiring so that the heights of the bonding pad of the semiconductor chip and the signal wiring are approximately equal. The semiconductor chip is encapsulated by a cap positioned from above. This cap is of a metal material and is then grounded to enhance isolation between the signal wirings and the bonding wires.

It is then necessary to match the impedance of transmission line with a load impedance for high frequency transmission at several tens of GHz.

In addition, the high frequency transmission line often has a load impedance of 50 ohms and therefore its termination resistor is also set to 50 ohms. Hence, the impedance of inpackage wiring is often formed by a microstrip line or strip line of 50 ohms. The microstrip line is usually formed by a dielectric material (insulator), a strip conductor (wiring conductor) on the surface thereof and a conductor at the lower part of the dielectric material (grounding plate). The strip line has a structure in which a strip conductor is buried within the dielectric material. The impedance of such a transmission line is determined uniquely from the width and thickness of the strip conductor and the thickness of the insulator (dielectric material). However, the impedance fluctuates significantly (about ±15%) depending on fluctuation (material, sizes, etc.) on the manufacturing process. Moreover, since it is impossible to compensate for impedance of the transmission line, the transmission line must change in size to change the impedance.

Since the impedance of transmission lines at each terminal of semiconductor element (chip) encapsulated in the semiconductor package may not always be exactly 50 ohms, the impedance of transmission line must be adjusted in order to achieve impedance matching in accordance with respective impedances in the microwave band. As an example of package wiring in the microwave package, electrodes (terminals) of the chip and the lead frame are connected by the wiring for a connector such as an Au line or an Aℓ line.

In this case, the impedance matching described above is particularly difficult at the wires for the connector.

If the impedance is mis-matched, signals may be reflected and lost at the mis-matching points and hence the semiconductor element may malfunction.

Such microwave transmission packages are described in, for example, "FOUNDATIONS FOR MICROWAVE ENGINEERING" p372-373, of McGraw-Hill Inc., 1966, "NIKKEI ELECTRONICS" p90-91, issued on April 20, 1987, "NIKKEI MICRODEVICE" p47-49, issued in June, 1986, Nikkei McGraw-Hill Inc.

The inventor of the present invention has investigated signal lines formed as a strip line and microstrip line.

First, the signal wire is in the form of a flat belt with a thickness of about 20-25 μm. Therefore, if the signal wire has a width of about 0.2 mm but has a small sectional area, it has large inductance, wire resistance and wire capacitance, making it difficult to improve the propagation rate of a signal. Therefore, the signal wire must be short in order to reduce inductance, wire resistance and wire capacitance of signal wires. However, as described previously, it has been very difficult to make the wire short because the signal wire extends in a direction parallel to the main surface of the semiconductor chip, i.e. in the lateral direction, within the package.

In addition, as described above, since the ground conductor of a strip line or microstrip line is not provided on the stepped portion between the recessed region where the semiconductor chip of the package is located and the surface where the signal wire is located, the high frequency signal leaks therefrom and crosstalk is also generated between the signal wires.

Moreover, in the case of a semiconductor chip which operates at a high frequency band of several tens of GHz, a wire connecting the external terminal (bonding pad) and the lead is necessary, which also causes impedance mismatching.

Furthermore, the cap is flat and thin, the cap itself has large inductance and resistance and it exhibits self-oscillation at a frequency near 6 GHz-10 GHz because the bonding wire acts as an antenna and generates electromagnetic waves. This causes a deterioration in the high frequency transmission characteristics of the semiconductor device. The inductance and resistance of the cap can be reduced by making the cap thick but the height of the package is then increased. On the other hand, if the cap is flat as described, the distance to the bonding wire is considerable, and therefore it becomes difficult to shield the lines of electric force generated from the bonding wire. As a result, isolation between the bonding wires becomes insufficient, resulting in malfunction of the device due to the linkage of lines of electric forces. Accordingly, the signal wires interfere with each other.

The present invention seeks to overcome, or at least ameliorate, these problems, particularly the problem of impedance matching. The present invention proposes, therefore, that the transmission line(s) are used for impedance matching between the chip, package, and circuit for mounting the package. First wiring conductors (signal wires) are provided, and second wiring conductors are provided around them. The second wiring conductors may then act as constant voltage wires, and the result is that a structure similar to a coaxial cable in formed.

In this way the present invention may provide a technique for improving the reliability of a high speed semiconductor device, by preventing mutual effects between the signal wires when transmitting signals as high as several GHz to several tens of GHz.

The present invention also may provide a technique for preventing malfunction of elements by achieving impedance matching at respective transmission lines depending on the loads, compensating for mismatching at the wire part for the connector so that correct transmission of a microwave signal can be achieved.

Preferably, the signal wires and constant voltage wires are extended in the vertical direction to the main surface of the semiconductor chip.

Furthermore, the central region of cap encapsulating the package may be thicker than its peripheral part.

In a chip operating in the high frequency band (several tens of GHz), a Chebyshev type low-pass filter (lead end part) may be arranged on one or each transmission line and a bonding wire may be added to such filter.

Since the signal wires are shielded from each other, in the same degree as a coaxial cable, by the constant voltage wires provided around the signal wires, the isolation characteristic can be improved. Moreover, the impedance of the signal wires can be set to a desired value (for example 50 ohms) by adjusting the interval between the signal wires and constant voltage wires.

Moreover, in a semiconductor chip operating in the high frequency band, the frequency and impedance of relevant filter characteristics may be varied and impedance of individual transmission line can be matched depending on the load by forming the Chebyshey type low-pass filter and then adding the wire thereto.

Embodiments of the invention will now be described in detail, by way of example, with reference to the accompanying drawings, in which:

Fig. 1 is a sectional view of a semiconductor device according to a first embodiment of the present invention;

Fig. 2 is a plan view of the semiconductor device of Fig. 1 along the line II-II;

Fig. 3 is an enlarged plan view of the region III enclosed by a broken line of the semiconductor device shown in Fig. 2;

Fig. 4 is a schematic sectional view of a semiconductor device according to the present invention, illustrated respective connections of the metal film, internal constant voltage wire, external constant voltage wire, outer lead and cap;

Fig. 5 is a sectional view illustrating the structure of a semiconductor device according to a second embodiment of the present invention;

Fig. 6 is an enlarged plan view of the region in Fig. 5 in which signal wires of the semiconductor device are located.

Fig. 7 is an illustration for explaining inductance L and resistance R of the flat cap;

Fig. 8 is an illustration for explaining the inductance L and resistance R of the cap which has its central region thicker than its peripheral part;

Fig. 9 is an enlarged plan view of the region of the second embodiment at which the signal wires of the semiconductor device are provided;

Fig. 10 is an enlarged schematic diagram of the lead of Fig. 9;

Fig. 11 is a system diagram indicating relationship between a load impedance ($Z_L$) and transmission line impedances ($Z_O$, $Z_T$); and

Fig. 12 is a structural diagram of parts of a known device.

Embodiment I

First, a schematic diagram of structure of the semiconductor device as a whole will be explained.

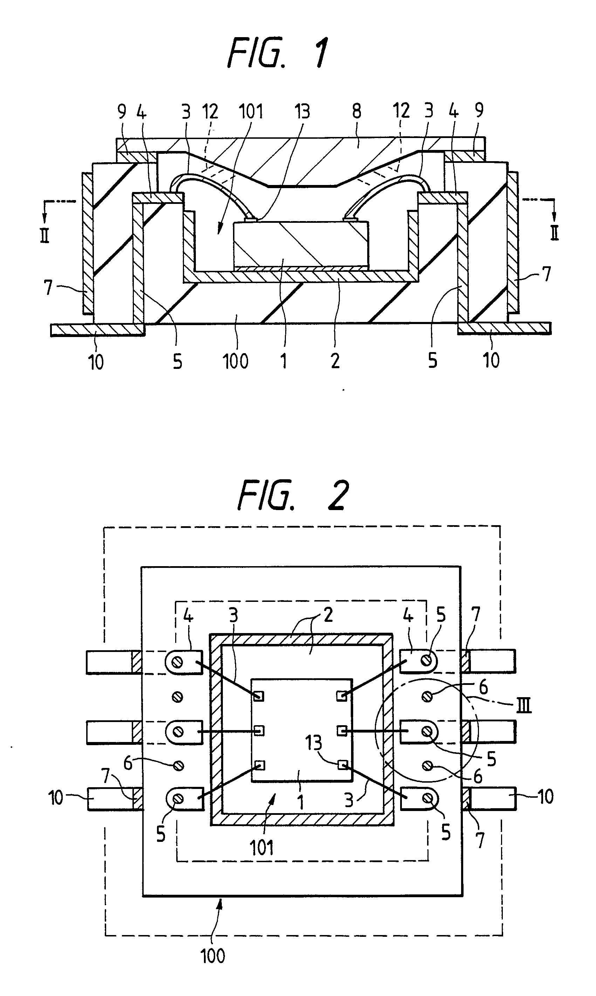

In Figs. 1 to 3, there is shown a substrate 100 of a package formed, for example, by ceramics ($Al_2O_3$). A semiconductor chip 1 (forming a circuit which provides the wiring of aluminum to the main surface consisting of single crystal silicon and GaAs, etc) is located at the bottom of a cavity (recessed part) 101 of the substrate 100 via a metal film 2. An external terminal (bonding pad) 13 on the semiconductor chip 1 is connected to the conductor 4 on the substrate 100 via a bonding wire 3.

A plurality of signal wires 5 are wiring conductors of the semiconductor device. The signal wires form columns at the external portion of the cavity 101 of the substrate 100. An internal constant voltage wire 6, which is also a wire conductor, is provided in the form of a column between the respective signal wires 5. There is an external constant voltage wire 7 at the external surface of the substrate 100 and the external constant voltage wire 7, internal constant voltage wire 6 and metal film 2 shield the signal wire 5. Here, the signal wire 5, constant voltage wires 6,7 are principally, for example of tungsten (W) including molybdenum (Mo). There is a cap 8 of metal material located on the substrate 100 via a metal film 9 and this cap 8 shields the bonding wire 3 and semiconductor chip 1 from the external electric field.

The metal film 2 is provided over almost the entire region of the wall surface from the bottom surface of cavity 101. In this way, leakage of the lines of electric force emitted from the signal wire 5 can be minimized by providing the metal film 2 up to the region near the conductor 4 at the wall surface of cavity 101. The signal wire 5 extends in the height direction of the substrate, i.e. in the direction perpendicular to the main surface of semiconductor chip 1 and the conductor 4 is connected to the upper end thereof. The conductor 4 is insulated from the metal film 2 in the cavity 101. The lower end of signal wire 5 is connected to the predetermined outer lead 10 among a plurality of outer leads 10 provided at the bottom surface of substrate 100. In the substrate 100, the power supply wire, namely the wire for feeding power supply voltage $V_{cc}$ and the wire for feeding the ground voltage $V_{ss}$ are provided and this power supply wire is also provided extending in the height direction of the substrate 100 as in the case of signal wire 5. The internal constant voltage wire 6 between the signal wires 5 is provided extending in parallel with the signal wire and in the same direction as the signal wire. The respective signal wires 5 and internal constant voltage wire 6 are arranged almost linearly. Here, the internal constant voltage wire 6 is provided between the wire for feeding the power supply and the signal wire 5, between the wire for feeding power supply and the wire for feeding the ground potential and between the wire for feeding the ground potential and the signal wire 5. These signal wire 5 and internal constant voltage wire 6 are formed, for example, by a column type conductor with the diameter of 0.2 mm. The external constant voltage wire 7 is formed like a plate and is provided at the position corresponding to the signal wire 5 at the side surface of substrate 100. Moreover, the external constant voltage wire 7 is forced to be longer than the signal wire 5 and provided up to the region near to the upper end from the lower surface of substrate 100. However, the external constant voltage wire 7 is insulated from the outer lead 10 connected with the signal wire 5. This external constant voltage wire 7, internal constant voltage wire 6, metal film 2 are arranged like a coaxial cable for the signal wire 5 as shown in Fig. 3. Here, the size between wires is determined in Fig. 3 as; X = 0.635mm, Y = 0.7 mm, Z = 0.3 mm.

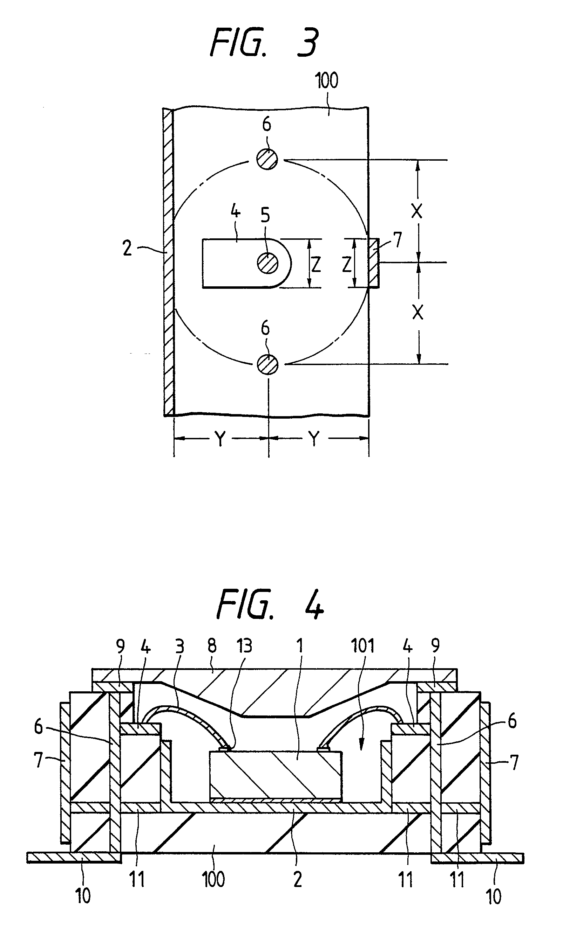

Moreover, the connecting relationship of metal film 2, internal constant wire 6, external constant voltage wire 7, outer lead 10 and cap 8 is shown in Fig. 4.

Fig. 4 is a schematic sectional view of a semiconductor device for explaining the respective connecting relationship among the metal film 2, internal constant voltage wire 6, external constant voltage wire 7, outer lead 10 and cap 8.

The external constant voltage wire 7, internal constant voltage wire 6 and metal film 2 are respectively connected by a connecting wire 11 in the substrate 100 and the upper end of the respective constant voltage wire 6 is connected to the cap 8 through the metal film 9 at the upper surface of substrate 100. For example, several internal voltage wires 6 are connected to the outer lead 10 for feeding a constant voltage, for example, the ground voltage $V_{ss}$, among the outer leads 10. Moreover, the predetermined wire among the internal constant voltage wires 5 is connected, through the bonding wire 3, to the bonding pad for feeding the constant voltage on the semiconductor chip 1, for example, the bonding pad for feeding the grounding voltage $V_{ss}$. The impedance of signal wire 5 can be set to various values by adjusting the distance up to the external constant voltage wire 7, internal constant voltage wire 6 and metal film 2 from the signal wire 5.

The cap 8 is formed thicker at the central region than the peripheral region so that the the central region at the lower surface is exposed toward the cavity 101. The thickness of peripheral region of cap 8 is, for example, about 150 $\mu$m, while the thickness of the central region thereof is about 500 $\mu$m.

The metal film 2, external constant voltage wire 7 and metal film 9 at the upper surface of substrate 100 are respectively formed by plating the tungsten (W) film with nickel (Ni) and then plating it with gold (Au). The substrate 100, signal wire 5, internal constant voltage wire 6 and connecting wire 11 are formed by stacking green sheets and then executing heat processing thereto. The conductor 4 is formed by tungsten (W) film the part exposed from the substrate 100 is placed with nickel (Ni) and then with gold (Au) thereon. The outer lead 100 and cap 8 are formed, for example, by 42-alloy (Ni: 42%, Fe : 58%).

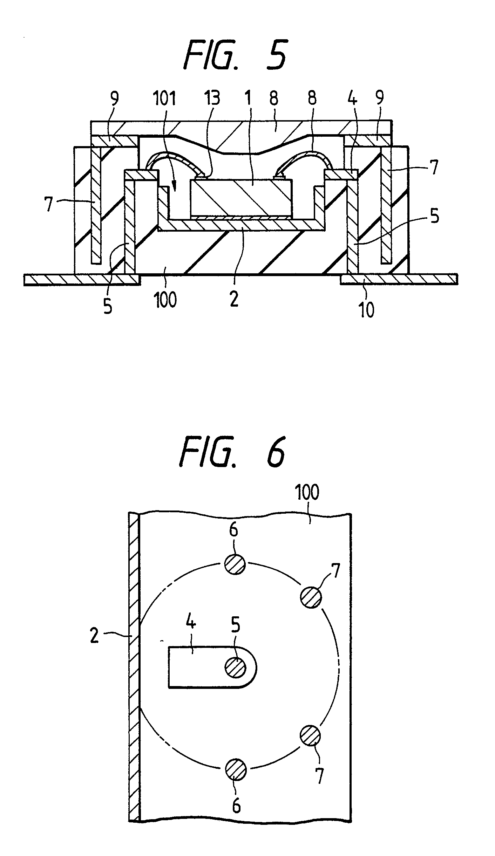

The semiconductor device of the present invention can also be formed as shown in Fig. 5 and Fig. 6.

Fig. 5 is an illustration for explaining the structure of a semiconductor device as the other embodiment different from an embodiment of the present invention shown in Fig. 1.

Fig. 6 is an enlarged plan view of the part providing the signal wire 5 of the semiconductor device shown in Fig. 5.

As shown in Fig. 5, the external constant voltage wire 7 is provided in the substrate 100. As shown in Fig. 6, the internal constant voltage wire 6, external constant voltage wire 7 and metal film 2 are respectively provided like a coaxial cable around the signal wire 5 to shield the signal wire 5.

The structure of the semiconductor device of this embodiment described above provides the following effects.

A plurality of constant voltage wires (consisting of internal constant voltage wire 6, external constant voltage wire 7 and metal film 2) are respectively provided like a coaxial cable in the coaxial direction to the signal wire 5 around the signal wire 5 in the semiconductor device providing the signal wire 5 in the substrate 100 of package encapsulating the semiconductor chip 1. Therefore, the signal wires 5 can be shielded in the same degree as the coaxial cable by such constant voltage wire. Accordingly, the isolation characteristics between signal wires 5 can be improved. Moreover, the impedance of signal wire 5 can be set to the predetermined value (for example, 50 ohms) by adjusting interval between the signal wire 5 and constant voltage wire (internal constant voltage wire 6, external constant voltage wire 7 and metal film 2).

Since almost a greater part of signal wire 5 is shielded by the metal film 2, internal constant voltage wire 6 and external constant voltage wire 7, leak of the line of electric force from the signal wire 5 can be lowered remarkably.

Meanwhile, since the signal wire 5 is provided in the height direction from the bottom surface to the upper surface of the substrate 100, the length of signal wire 5 can be extremely shortened and thereby the inductance L, wire resistance R and wire capacitance C can respectively reduced.

Moreover, since the signal wire 5 is formed by a column type conductor, it has a larger sectional area than the microstrip line of the same wire width and thereby the inductance L per unit length (for example, 1 mm) can be reduced to about 1/3 and the wire resistance R can also be reduced to about 1/8.

In addition, since the central region of cap 8 is formed thick, the central region thereof becomes near the bonding wire 3 and the line of electric force 12 emitted from the bonding wire 3 can be shielded and thereby isolation characteristics between the bonding wires 3 can be improved.

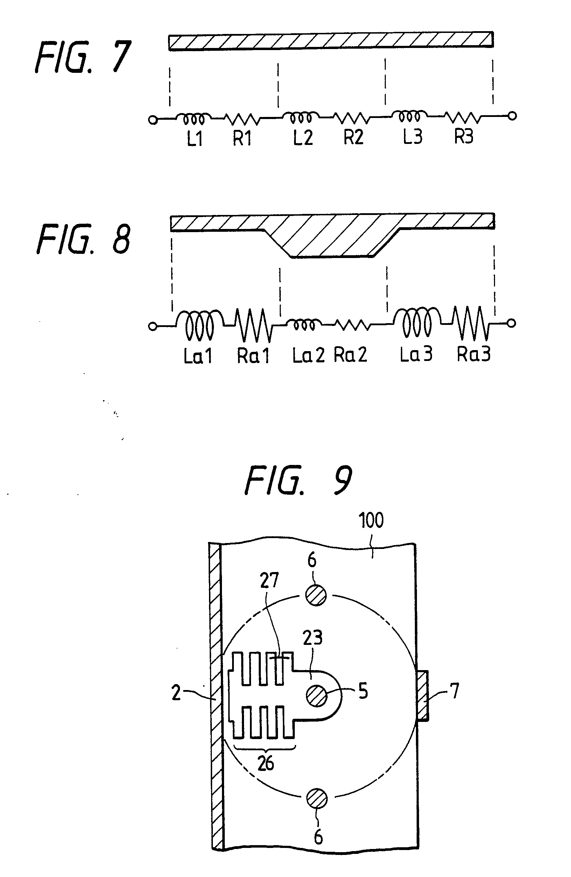

Next, it will then be explained with reference to Fig. 7 and Fig. 8 that the resonance frequency of the cap 8 itself can be increased by making thicker the central region of cap 8.

Fig. 7 is an illustration for explaining the distribution of inductance L and resistance R distributed in the flat cap 8.

Fig. 8 is an illustration for explaining the distribution of inductance L and resistance R of the cap 8 where the central region is formed thicker than the peripheral portion.

As shown in Fig. 7, when the cap 8 is formed flat, inductance L1 and resistance R1 of the peripheral part, inductance L2 and resistance R2 of the central region and inductance L3 and resistance R3 of the peripheral part opposite to such peripheral part become the same in any where, for example, at the peripheral part and central region of the cap 8. However, as shown in Fig. 8, since the central region is formed thick, inductance La1 and resistance Ra2 of the central region become smaller than inductance L2 and resistance R2 of the central region of the flat type cap 8 (L2 > La2, R2 > Ra2). Thereby, the resonance frequency of cap 8 can be set higher than the frequency of signal current flowing into the signal wire 5 and bonding wire 3.

From these advantages, inductance L of the semiconductor device of this embodiment can be lowered to about 1/2-1/3 in the device as a whole in comparison with that of the prior art device, while the wire capacitance to about 1/10 and wire resistance to about 1/20-1/30.

In the embodiment I, the signal wires are shielded in the same degree as the coaxial cable by the constant voltage wire and therefore the isolation characteristics of signal wires can be improved. Moreover, impedance of signal wires can be set to the predetermined value (for example, 50 ohms) by adjusting the interval between the signal wires and constant voltage wires (internal constant voltage wire, external constant voltage wire and metal film).

Embodiment II

Next, the other embodiment of the present invention will be explained with reference to Fig. 9 to Fig. 12.

First, the impedance matching is outlined hereunder.

According to the analytic theory of transmission line, following relationship can be defined between an impedance ($Z_L$) of a load 21 of semiconductor chip and impedances of transmission line 22 ($Z_O$, $Z_T$) in the inpackage wire of the semiconductor package for microwave transmission.

$$Z_T = \sqrt{Z_O \cdot Z_L} \qquad (1)$$

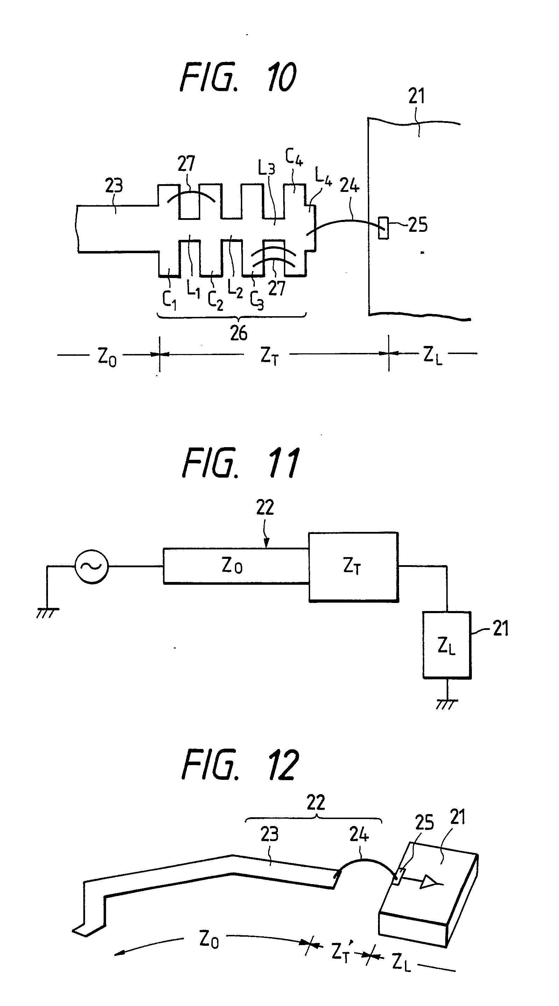

Fig. 12 is an illustration of the inpackage wire in the microwave transmission of the prior art. In this figure, 21 is load and 22 is transmission line indicating an example where the transmission line 22 is composed of the conductor 23 made of tungsten W metal and the wire 24 for connector. Moreover, 25 is external terminal (bonding pad) of semiconductor chip.

In the inpackage wire of the prior art structure, the impedance at the connecting part by the wire 24 for connector is indicated as $Z_T'$. Namely, as shown in Fig. 11, the impedance $Z_T$ must be set to $Z_T = \sqrt{Z_O \cdot Z_L}$ in order to match the impedance $Z_O$ of transmission line 22 with the load impedance $Z_L$.

However, it is intrinsically impossible to adjust the impedance $Z_T'$ of the wire 24 for connector and the impedance $Z_O$ cannot be matched with the load impedance $Z_L$.

On the other hand, it is certain, from the relationship described above $Z_T = \sqrt{Z_O \cdot Z_L}$, that it is enough to alter $Z_T$ depending on the load impedance $Z_L$. Here, the range of length of impedance $Z_T$ is 1/4 of the waveform ($\lambda$) of signal.

Fig. 9 and Fig. 10 are illustrations of the embodiment II of the present invention.

Referring to Fig. 9, the embodiment II is applied to a conductor 4 shown in Fig. 3. That is, a Chebyshev type low-pass filter 26 for fixing the frequency is provided at the extreme end part of the conductor 23 connected to the upper end of signal wire 5. The bonding wire 27 is arranged on this filter 25 for finer adjustment of impedance matching and adjustment in change of frequency band.

The relevant low-pass filter 26 includes inductances ($L_1$-$L_4$) and capacitances ($C_1$-$C_4$). Designing has approximated the impedance of this low-pass filter 26 to the impedance $Z_T$. Adjustment of impedance can be accomplished by changing sizes (width, length) of the inductances ($L_1$-$L_4$) or capacitances ($C_1$-$C_4$). However in adjustment of impedance $Z_T$ depending on the load $Z_L$, the fine adjustment has been realized by adding the bonding wire 27 in this embodiment in order to change L in relationship,

$$Z_T \sqrt{LC} \qquad (2)$$

with the reactance element (mainly, inductance: L) of the bonding wire and then satisfying the relationship $Z_T = \sqrt{Z_O \cdot Z_L}$ mentioned through the matching of $Z_O$ and $Z_L$. Namely, addition of bonding wire 27 reasonably changes the frequency characteristics and impedance of the low-pass filter property and thereby an impedance of $Z_T$ can be adjusted in accordance with the load $Z_L$.

In the embodiment II, three bonding wires 27 are added, and the inductance L mentioned can be adjusted by changing the number of bonding wires 27 or the length thereof.

Moreover, in this embodiment II, the low-pass filter 26 is connected to the end point of conductor 23, the capacitors $C_1$-$C_2$ of filter 26 are connected through a single bonding wire 27, the capacitors $C_3$-$C_4$ are connected through a couple of bonding wires 27, 27 and the inductance $L_4$ of filter 26 and external terminal 25 of chip 1 are connected through the wire bonding by the wire 24 for connector. However, the bonding wire 27 may be added between the inductances (for example, between $L_1$ and $L_2$) or between the capacitance (for example, $C_1$-$C_4$) and inductances (for example, $L_1$-$L_4$).

According to this embodiment II, impedance adjustment can be executed in accordance with respective load 21 of the inpackage transmission line by utilizing the low-pass filter 26 provided at the conductor 23 as the transmission line.

In addition, in case a higher frequency (on the order of several tens of GHz) is used, loss by resonance of conductor plate further increases but fine adjustment of impedance and change of frequency band can be executed by adequately connecting the capacitors $C_1$-$C_4$ and inductances $L_1$-$L_4$ of the low-pass filter 26 used in the embodiment II with the bonding wire 27.

Furthermore, mismatching of impedance of bonding wire 24 connecting the external terminal 25 of chip 1 and conductor 23 can also be compensated.

The proper microwave signal (particularly, a high frequency on the order of several tens of GHz) can also be transmitted.

In the foregoing explanation, the inpackage wiring utilizing conductor wire of tungsten (W) metal in the ceramic package has been taken into consideration and this inpackage wiring can also be applied to inpackage wiring using a lead frame.

## Claims

1. A semiconductor device comprising:
a semiconductor chip on the main surface of which are circuitry and external terminals,
a substrate having a metal film at a region to which the semiconductor chip is secured,
a plurality of wires for electrically connecting the external terminals and a plurality of conductors,

a plurality of first wiring conductors within the substrate and extending in a direction generally perpendicular to the main surface of the semiconductor chip with one end thereof being connected to the conductor,

second wiring conductors within the substrate, the second wiring conductors being spaced apart around respective ones of the first wiring conductors, and

a metal cap encapsulating the semiconductor chip, wires, metal film and conductors.

2. A semiconductor device according to claim 1, wherein the central region of the metal cap is thicker than the peripheral part thereof.

3. A semiconductor device according to claim 1 or claim 2, wherein the metal film is a tungsten (W) film plated with nickel (Ni) and gold (Au).

4. A semiconductor device according to any one of the preceding claims, wherein the plurality of conductors are of tungsten (W) film.

5. A semiconductor device according to any one of the preceding claims, wherein the first and second wiring conductors are mainly of tungsten (W).

6. A semiconductor device according to any one of the preceding claims, wherein at least one of the second wiring conductors is at the outside of the substrate.

7. A semiconductor device according to any one of the preceding claims, wherein the first wiring conductors are column type conductors.

8. A semiconductor device according to any one of the preceding claims, wherein the first and second wiring conductors and a part of the metal film are substantially parallel.

9. A semiconductor device according to any one of the preceding claims, wherein there is a Chebyshev type filter connected to at least one of the first wiring conductors.

10. A semiconductor device according to claim 9, wherein there is a wire connected to the Chebychev type filter.

11. A semiconductor device according to claim 9 or claim 10, wherein the Chebychev type filter is of tungsten film.

*FIG. 1*

*FIG. 2*

# FIG. 3

# FIG. 4

# FIG. 5

# FIG. 6

*FIG. 7*

L1  R1  L2  R2  L3  R3

*FIG. 8*

La1  Ra1  La2  Ra2  La3  Ra3

*FIG. 9*

## FIG. 10

## FIG. 11

## FIG. 12